(19) Europäisches Patentamt
European Patent Office
Office européen des brevets

(11) Veröffentlichungsnummer: **0 153 904**
**B1**

(12) # EUROPÄISCHE PATENTSCHRIFT

(45) Veröffentlichungstag der Patentschrift: **14.09.88**

(51) Int. Cl.⁴: **G 03 C 1/68,** C 07 F 7/10, C 08 G 59/68

(21) Anmeldenummer: **85810039.9**

(22) Anmeldetag: **04.02.85**

(54) **Verfahren zur Herstellung einer Schutzschicht oder einer Reliefabbildung.**

(30) Priorität: **10.02.84 CH 631/84**

(43) Veröffentlichungstag der Anmeldung: **04.09.85 Patentblatt 85/36**

(45) Bekanntmachung des Hinweises auf die Patenterteilung: **14.09.88 Patentblatt 88/37**

(84) Benannte Vertragsstaaten: **AT CH DE FR GB IT LI NL**

(56) Entgegenhaltungen:
**EP - A - 0 094 915**
**EP - A - 0 104 144**
**GB - A - 2 053 243**
**US - A - 4 026 705**
**US - A - 4 058 401**

(73) Patentinhaber: **CIBA-GEIGY AG, Klybeckstrasse 141, CH-4002 Basel (CH)**

(72) Erfinder: **Zweifel, Hans, Dr., Leuengasse 4, CH-4057 Basel (CH)**
Erfinder: **Bauer, Sigrid, Dr., 61, route de Taillepied, CH-1095 Lutry (CH)**
Erfinder: **Meier, Kurt, Dr., Ulmenstrasse 11, CH-4124 Allschwil (CH)**

**EP 0 153 904 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein Verfahren zum Aufbringen von Schutzschichten oder Reliefabbildungen auf einem Substrat, bei dem eine strahlungsempfindliche Schicht aus einem festen filmbildenden Epoxidharz und einem strahlungsaktivierbaren Photoinitiator auf das Substrat übertragen, darauf direkt oder unter einer Photomaske belichtet und danach thermisch gehärtet wird, worauf gegebenenfalls die unbelichteten Anteile mit einem Lösungsmittel entwickelt werden.

In der deutschen Patentschrift 15 22 515 ist ein Verfahren zur Herstellung von gedruckten Schaltungen beschrieben, bei dem eine lichtempfindliche Schicht von einem Trägermaterial auf ein Substrat übertragen wird und danach die üblichen photographischen Verfahrensschritte zur Erzeugung einer Reliefabbildung durchgeführt werden. Dieses Verfahren hat gegenüber einem direkten Aufbringen der lichtempfindlichen Schicht auf ein Substrat, z.B. mittels einer Beschichtungslösung, erhebliche technische Vorteile.

Die bisher bekanntgewordenen Photoresistlaminate aus Träger und lichtempfindlicher Schicht weisen jedoch Nachteile auf, die hauptsächlich auf die Verwendung von flüssigen mehrfunktionellen Acrylat- bzw. Methacrylatmonomeren als photovernetzbare Verbindungen, gegebenenfalls zusammen mit Bindemitteln, zurückzuführen sind. Die mit Hilfe dieser Laminate hergestellten gehärteten Schutzschichten oder Reliefstrukturen genügen nicht den hohen thermischen Anforderungen, die z.B. bei der Weiterverarbeitung von Leiterplatten in Lötbädern auftreten. Dieser Nachteil kann auch nicht durch die Zugabe von Vernetzungsmitteln (vergleiche z.B. EP-A-0 073 444) vollständig behoben werden. Die bekannten Laminate haben ferner den Nachteil, daß die photovernetzbare Schicht wegen der in ihr vorhandenen Monomeren sauerstoffempfindlich ist und daher nur unter besonderen Schutzmaßnahmen verarbeitet werden kann. So muß z.B. die Belichtung durch eine die lichtempfindliche Schicht abdeckende transparente Schutzfolie erfolgen, was, bedingt durch die auftretende Lichtstreuung, eine Verringerung der Auflösung zur Folge hat. Der den thermoplastischen Resistschichten eigene Kaltfluß bedingt ferner, daß die klebrigen lichtempfindlichen Schichten an den Rändern der üblicherweise aufgerollten Laminate austreten, wodurch das Material unbrauchbar wird.

Es ist auch bekannt, daß Epoxidharze mit kationischen Photoinitiatoren vernetzt und daß diese Mischungen zur photographischen (= photomechanischen) Erzeugung von Reliefabbildungen verwendet werden können, vergleiche E. Irving et al., Brit. Polym. J., 15, S. 24 ff. (1983). Daß solche Mischungen als thermisch übertragbare stahlungsempfindliche Schichten verwendet werden können, ist jedoch nicht erwähnt.

Es wurde nun überraschend gefunden, daß sich feste Epoxidharze, die einen strahlungsempfindlichen Photoinitiator für die Polyaddition enthalten, hervorragend als photosensitive Schichten eignen, die sich einfach von einem Trägermaterial auf ein Substrat übertragen lassen und direkt, ohne Verwendung einer sie abdeckenden Schutzfolie (im vorliegenden Fall die Trägerfolie) bestrahlt werden können, wodurch optimale Auflösungen erzielt werden. Das im Verfahren verwendete Laminat zeichnet sich auch durch eine hohe Lagerstabilität aus.

Gegenstand vorliegender Erfindung ist ein Verfahren zur Herstellung einer Schutzschicht oder einer Reliefabbildung auf einem Substrat, bei dem eine strahlungsempfindliche Schicht von einem Trägermaterial auf das Substrat übertragen, darauf direkt oder unter einer Photomaske belichtet und danach thermisch gehärtet wird, worauf gegebenenfalls die unbelichteten Anteile mit einem Lösungsmittel entwickelt werden, das dadurch gekennzeichnet ist, daß die strahlungsempfindliche Schicht aus einem festen filmbildenden Epoxidharz besteht, das einen strahlungsaktivierbaren Photoinitiator für die Polyaddition enthält.

Das feste Epoxidharz weist bevorzugt ein Epoxidäquivalentgewicht von 1 bis 5 Äquivalenten pro kg Harz auf.

Bei den Epoxidharzen kann es sich z.B. um Glycidyläther von Novolaken aus gegebenenfalls substituierten Phenolen, wie z.B. Xylenol, Kresol, Resorcin, und besonders Phenol und Aldehyden, wie z.B. Acetaldehyd und besonders Formaldehyd, handeln.

Eine weitere bevorzugte Gruppe von Epoxidharzen sind die Glycidyläther von Bisphenolen. Hierbei kann es sich um Monomere, Oligomere oder bevorzugt niedermolekulare Polymere mit einem mittleren Molekulargewicht $\overline{M_\omega}$ von etwa 1000 bis 10000 handeln. Bevorzugt ist das Molekulargewicht 1000 bis 6000.

Die Bisphenole können durch folgende Formel dargestellt werden:

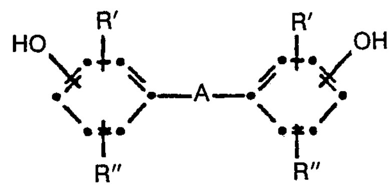

Die Hydroxylgruppen können sich in m-Stellung, besonders aber in p-Stellung befinden, R′ und R″ können in dieser Formel Alkyl mit 1 bis 6 C-Atomen, Halogen wie Chlor oder Brom und insbesondere Wasserstoffatome bedeuten. A kann für eine direkte Bindung stehen, oder

$$O,\ \overset{\overset{O}{\|}}{C},\ O\overset{\overset{O}{\|}}{C},\ O\overset{\overset{O}{\|}}{C}O,\ NR''',\ S,\ SO,\ SO_2,$$

gegebenenfalls substituiertes Alkyliden, Cycloalkyliden oder Alkylen bedeuten. R‴ steht für ein Wasserstoffatom, Phenyl oder Alkyl mit 1 bis 6 C-Atomen.

Beispiele für gegebenenfalls substituiertes Alkyliden sind Äthyliden, 1,1- oder 2,2-Propyliden, 2,2-Butyliden, 1,1-Isobutyliden, Dichloräthyliden und Trichloräthyliden. Beispiele für gegebenenfalls substituiertes Alkylen sind Methylen, Äthylen, Phenylmethylen, Diphenylmethylen, Methylphenylmethylen. Beispiele für Cycloalkyliden sind Cyclopentyliden und Cyclohexyliden.

Beispiele für Bisphenole sind:

Bis-(p-hydroxyphenyl)-äther oder -thioäther, Bis-(p-hydroxyphenyl)-sulfon, Bis-(p-hydroxyphenyl)-methan, 1,2-Bis-(p-hydroxyphenyl)-äthan, Phenyl-bis-(p-hydroxyphenyl)-methan, Diphenyl-bis-(p-hydroxyphenyl)-methan, 2,2-Bis-(4′-hydroxy-3′,5′-dimethylphenyl)-propan, 1,1- oder 2,2-Bis-(p-hydroxyphenyl)-butan, 1,1-Dichlor- oder 1,1,1-Trichlor-2,2-bis-(p-hydroxyphenyl)-äthan, 1,1-Bis-(p-hydroxyphenyl)-cyclopentan und besonders 2,2-Bis-(p-hydroxyphenyl)-propan (Bisphenol A) und 1,1-Bis-(p-hydroxyphenyl)-cyclohexan (Bisphenol C).

Die Epoxidharze umfassen auch feste vorreagierte Harze, die durch Reaktion von Polyepoxidverbindungen mit geeigneten Härtern wie z.B. aliphatischen, cycloaliphatischen oder aromatischen Polyamiden, Polyolen und Polycarbonsäuren, erhältlich sind. Hierfür geeignete Polyepoxidverbindungen sind z.B. aliphatische, cycloaliphatische oder aromatische Verbindungen. Beispiele für solche Verbindungen sind die Glycidyläther und β-Methylglycidyläther aliphatischer oder cycloaliphatischer Diole oder Polyole, zum Beispiel solche des Äthylenglykols, Propan-1,2-diols, Propan-1,3-diols, Butan-1,4-diols, Diäthylenglykols, Polyäthylenglykols, Polypropylenglykols, Glycerins, Trimethylolpropans oder 1,4-Dimethylolcyclohexans oder des 2,2-Bis-(4-hydroxycyclohexyl)-propans und N,N-Bis-(2-hydroxyäthyl)-anilins; die Glycidyläther von Di- und Polyphenolen, beispielsweise Resorcin, 4,4′-Dihydroxydiphenylmethan, 4,4′-Dihydroxydiphenyl-2,2-propan, Novolake und 1,1,2,2-Tetrakis-(4-hydroxyphenyl)-äthan. Weitere Beispiele sind N-Glycidylverbindungen, z.B die Diglycidylverbindungen des Äthylenharnstoffs, 1,3-Propylenharnstoffs oder 5-Dimethylhydantoins oder des 4,4′-Methylen-5,5′-tetramethyldihydantoins, oder solche wie Triglycidylisocyanurat.

Weitere Glycidylverbindungen mit technischer Bedeutung sind die Glycidylester von Carbonsäuren, insbesondere Di- und Polycarbonsäuren. Beispiele dafür sind die Glycidylester der Bernsteinsäure, Adipinsäure, Azelainsäure, Sebacinsäure, Phthalsäure, Terephthalsäure, Tetra- und Hexahydrophthalsäure, Isophthalsäure oder Trimellitsäure, oder von dimerisierten Fettsäuren.

Beispiele für von Glycidylverbindungen verschiedene Polyepoxide sind die Diepoxide des Vinylcyclohexens und Dicyclopentadiens, 3-(3′,4′-Epoxicyclohexyl)-8,9-epoxy-2,4-dioxaspiro[5,5]undecan, der 3′,4′-Epoxicyclohexylmethylester der 3,4-Epoxicyclohexancarbonsäure, Butadiendiepoxid oder Isoprendiepoxid, epoxidierte Linolsäurederivate oder expoxidiertes Polybutadien.

Die genannten Epoxide können auch für sich durch katalytische Härtung zu filmbildenden und festen Epoxidharzen vorreagiert werden.

Ebenfalls bevorzugte Epoxidharze sind vorverlängerte Epoxidverbindungen, besonders Diglycidyläther zweiwertiger Phenole oder zweiwertiger aliphatischer Alkohole mit 2 bis 4 Kohlenstoffatomen. Besonders bevorzugt werden die vorverlängerten Diglycidyläther des 2,2-Bis-(4-hydroxyphenyl)-propans und Bis-(4-hydroxyphenyl)-methans. Als Vorverlängerungsmittel dienen bevorzugt Bisphenole, z.B. solche der zuvor definierten Art, besonders Bisphenol-A und Tetrabrombisphenol-A.

Die im erfindungsgemäßen Verfahren zu verwendenden festen und filmbildenden Epoxidharze sind bekannt oder käuflich oder nach bekannten Verfahren erhältlich. Die mit diesen Epoxidharzen hergestellten strahlungsempfindlichen Schichten sind bevorzugt auch klebfrei, damit sich die bei der Belichtung gegebenenfalls verwendete Photomaske rückstandsfrei und unbeschädigt von der Schicht entfernen läßt.

Für die zur Vernetzung der Epoxidharze führende Polyaddition geeignete strahlungsaktivierbare Photoinitiatoren sind eine Vielzahl unterschiedlicher kationischer Verbindungen bekanntgeworden, vergleiche Brit. Polymer J. 15, S. 24ff. (1983), und J. Macromol. Sci. Macromol. Rev. C 21, S. 187ff. (1981).

Als besonders geeignet haben sich Oniumsalze erwiesen, besonders solche mit wenig nukleophilen Anionen. Solche Anionen sind z.B. die Halogenkomplexanionen von zweiwertigen bis siebenwertigen Metallen oder Nichtmetallen, z.B. Sb, Sn, Fe, Bi, Al, Ga, In, Ti, Zr, Sc, V, Cr, Hf und Cu sowie B, P und As. Das Halogen ist bevorzugt F. Beispiele sind $BF_4^-$, $BF_6^-$, $AsF_6^-$, $SbF_6^-$.

Als Oniumsalze sind z.B. Aryldiazoniumsalze und Oniumsalze der Gruppen Va, VIa und VIIa des Periodsystems geeignet, z.B. Haloniumsalze, besonders aromatische Jodonium- und Jodoxoniumsalze, quaternäre Ammonium-, Phosphonium- und Arsoniumsalze, aromatische Sulfoniumsalze und Sulfoxoniumsalze bzw. Selenoniumsalze.

Unter den Haloniumsalzen sind solche der Formel II bevorzugt,

$$[R^3R^4X]^+_q \; [LQ_m]^{-q} \qquad (II)$$

worin $R^3$ und $R^4$ unabhängig voneinander ein carbozyklischer oder heterozyklischer aromatischer Rest mit 6 bis 20 C-Atomen oder $R^3$ und $R^4$ zusammen ein zweiwertiger carbozyklischer oder heterozyklischer aromatischer Rest sind, X für ein Halogenatom steht, m eine Zahl ist, die der Summe der Wertigkeit von L und q entspricht, L ein zweiwertiges bis siebenwertiges Metall oder Nichtmetall und Q ein Halogenatom darstellen, und q eine Zahl von 1 bis 3 bedeutet.

$R^3$ und $R^4$ können durch einen oder mehr einwertige Reste substituiert sein, z.B. Alkyl oder Alkoxy mit 1 bis 8 C-Atomen, Halogen wie F, Cl oder Br, Nitro oder Cyano. Beispiele sind Phenyl, Toluyl, Xylyl, Chlorphenyl, Nitrophenyl, Methoxyphenyl und Pyridyl. $R^3$ und $R^4$ zusammen können z.B. 2,2′-Biphenylen oder 2,2′-Bipyridyl sein. Bevorzugte Anionen sind zuvor erwähnt. X steht besonders für Jod und q besonders für 1. Q ist bevorzugt Cl und besonders F. Die Jodoniumsalze sind z.B. in der DE-A-2 518 639 beschrieben. Besonders bevorzugt ist Diphenyljodoniumhexafluorphosphat.

Eine weitere bevorzugte Gruppe sind Jodosylsalze der Formel IV

$$[R^8R^9J^+=O]_q \; [LQ_m]^{-q} \qquad (IV),$$

worin $R^7$ und $R^8$ ein carbozyklischer oder heterozyklischer aromatischer Rest mit 6 bis 20 C-Atomen sind, m eine Zahl ist, die der Summe der Wertigkeit von L und q entspricht, L ein zweiwertiges bis siebenwertiges Metall oder Nichtmetall und Q ein Halogenatom darstellen, und q eine Zahl von 1 bis 3 bedeutet.

$R^8$ und $R^9$ sind bevorzugt Phenyl oder Naphthyl, die ein- oder mehrfach substituiert sein können, z.B. mit $C_1$–$C_4$-Alkyl oder -Alkoxy, Phenyl, Nitro oder Halogen. Bevorzugte Anionen sind zuvor erwähnt. Q ist bevorzugt Cl und besonders F, und q steht bevorzugt für 1. Ein Beispiel für diese Salze ist Diphenyljodosylhexafluorphosphat oder -antimonat. Die Jodosylsalze sind z.B. durch die Reaktion von Diaryljodosylhydroxid mit einer Säure $H_q[LQ_m]^{q-}$ oder deren Ammoniumsalzen in wäßriger oder organischen wäßrigen Lösungen bei Temperaturen von etwa 0 °C bis 30 °C erhältlich.

Eine weitere bevorzugte Gruppe sind Sulfoniumsalze der Formel III

$$[R^5R^6R^7S]^{+}{}_q\ [LQ_m]^{-q} \qquad \text{(III)},$$

worin $R^5$, $R^6$ und $R^7$ unabhängig voneinander einen carbozyklischen oder heterozyklischen aromatischen Rest mit 6 bis 20 C-Atomen oder eines von $R^5$, $R^6$ und $R^7$ diesen aromatischen Rest und die beiden anderen zusammen einen zweiwertigen carbozyklischen oder heterozyklischen aromatischen Rest bedeuten, m eine Zahl ist, die der Summe der Wertigkeit von L und q entspricht, L ein zweiwertiges bis siebenwertiges Metall oder Nichtmetall und Q ein Halogenatom darstellen, und q eine Zahl von 1 bis 3 bedeutet.

Bevorzugt sind $R^5$, $R^6$ und $R^7$ carbozyklische aromatische Reste wie Phenyl oder Naphthyl. Diese können ein- oder mehrfach substituiert sein, z.B. durch $C_1$-$C_4$-Alkyl, $C_1$-$C_4$-Alkoxy, Phenyl, Nitro oder Halogen. Q steht bevorzugt für Cl, und besonders F und q ist bevorzugt 1. Ein Beispiel ist Triphenylsulfoniumhexafluorphosphat oder -antimonat.

Geeignete Sulfoxoniumsalze sind z.B. in den amerikanischen Patenten 4 383 025, 4 398 014 und 4 299 938 beschrieben.

Weitere geeignete Photoinitiatoren sind Metallcarbonylverbindungen, Metallocene und Metallocencarbonylkomplexe.

Eine bevorzugte Gruppe sind Salze der Formel I

$$[Y\text{–}Q^1\text{–}(CO)_b]^+M^1X_n^- \qquad \text{(I)},$$

worin Y eine Arengruppe oder Dienyliumgruppe bedeutet, $Q^1$ ein Atom eines unter Titan, Vanadium, Chrom, Mangan, Eisen, Kobalt, Nickel, Kupfer; Niob, Molybdän, Ruthenium, Rhodium, Palladium, Silber; Tantal, Wolfram, Rhenium, Osmium, Iridium, Platin und Gold ausgewählten d-Block-Übergangsmetalls darstellt, b eine solche positive ganze Zahl ist, daß das Atom $Q^1$ eine geschlossene Elektronenschalenkonfiguration aufweist, $M^1$ ein Atom eines Metalls oder Nichtmetalls darstellt, n 4, 5 oder 6 und um eins größer als die Wertigkeit von $M^1$ ist und X für ein Fluor- oder Chloratom steht, mit der Maßgabe, daß, wenn $M^1$ Antimon darstellt, n 6 ist und fünf der Symbole X für Fluor stehen, eines auch eine Hydroxygruppe bedeuten kann.

Wenn Y eine Arengruppe bedeutet, d.h. selbst ein 6-Elektronen-Ligand ist, so kann es eine einkernige oder mehrkernige Gruppe, einschließlich einer kondensierten Ringgruppe, sein. Vorzugsweise ist es eine gegebenenfalls durch eine oder mehrere Alkoxygruppen substituierte Kohlenwasserstoffgruppe und enthält vorzugsweise 6 bis 18 Kohlenstoffatome, wie Benzol, Toluol, Mesitylen, Naphthalin, Biphenyl, Phenanthren, Fluoren und Anthracen.

Wenn Y eine Dienyliumgruppe bedeutet, so ist es vorzugsweise eine zyklische Gruppe einer der folgenden Formeln

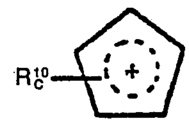
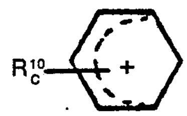
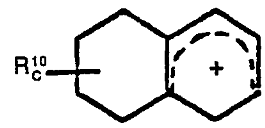
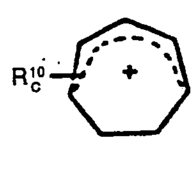
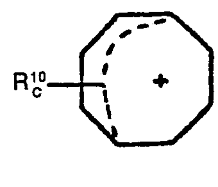

worin $R^{10}$ für eine Alkylgruppe mit 1 bis 4 Kohlenstoffatomen, eine Alkoxygruppe mit 1 bis 4 Kohlenstoffatomen oder eine durch eine oder mehrere Oxycarbonylgruppen unterbrochene Alkylgruppe mit bis zu 12 Kohlenstoffatomen steht und c null, 1, 2 oder 3 ist.

$Q^1$ steht vorzugsweise für Chrom, Kobalt, Nickel und insbesondere Eisen oder Mangan.

Das Atom $M^1$ kann beispielsweise Eisen, Zinn, Wismut, Aluminium, Gallium, Indium, Titan, Zirkon, Scandium, Vanadium, Chrom oder Mangan, jedoch vorzugsweise Antimon, Arsen, Bor oder Phosphor darstellen. Das Anion $M^1X_n^-$ kann somit beispielsweise Tetrachloraluminat oder Hexachlorferrat bedeuten, doch steht es vorzugsweise für Tetrafluorborat, Hexafluorarsenat, Hydroxypentafluorantimonat, Hexafluorantimonat oder Hexafluorphosphat.

Solche Salze sind z.B. in der EP-A-0 094 914 beschrieben.

Eine besonders bevorzugte Gruppe von Photoinitiatoren sind solche der Formel

$$[(R^1)(R^2M)_a]^{+an}\ \frac{an}{q}\ [LQ_m]^{-q} \qquad \text{(I)},$$

worin a 1 oder 2 sowie n und q unabhängig voneinander je eine ganze Zahl von 1 bis 3 sind, M das Kation eines einwertigen bis dreiwertigen Metalls aus Gruppe IVb bis VIIb, VIII oder Ib des Periodensystems darstellt, m eine ganze Zahl ist, die der Summe der Wertigkeit von L und q entspricht, und Q ein Halogenatom, L ein zweiwertiges bis siebenwertiges Metall oder Nichtmetall, $R^1$ ein π-Aren und $R^2$ ein π-Aren oder das Anion eines π-Arens bedeuten.

Als π-Arene $R^1$ und $R^2$ kommen insbesondere aromatische Gruppen mit 6 bis 24 Kohlenstoffatomen oder heteroaromatische Gruppen mit 3 bis 30 Kohlenstoffatomen in Betracht, wobei diese Gruppen gegebenenfalls durch gleiche oder verschiedene einwertige Reste wie Halogenatome, vorzugsweise Chlor- oder Bromatome, oder $C_1$–$C_8$-Alkyl-, $C_1$–$C_8$-Alkoxy-, Cyan-, $C_1$–$C_8$-Alkylthio-, $C_2$–$C_6$-Monocarbonsäurealkylester-, Phenyl-, $C_2$–$C_5$-Alkanoyl- oder Benzoylgruppen einfach oder mehrfach substituiert sein können. Diese π-Arengruppen können einkernige, kondensierte mehrkernige oder unkondensierte mehrkernige Systeme darstellen, wobei in den zuletzt genannten Systemen die Kerne direkt oder über Brückenglieder wie –S– oder –O– verknüpft sein können.

$R^2$ als das Anion eines π-Arens kann ein Anion eines π-Arens der obengenannten Art sein, zum Beispiel das Indenylanion und insbesondere das Cyclopentadienylanion, wobei auch diese Anionen gegebenenfalls durch gleiche oder verschiedene einwertige Reste wie $C_1$–$C_8$-Alkyl-, $C_2$–$C_6$-Monocarbonsäurealkylester-, Cyan-, $C_2$–$C_5$-Alkanoyl- oder Benzoylgruppen einfach oder mehrfach substituiert sein können.

Die Alkyl-, Alkoxy-, Alkylthio-, Monocarbonsäurealkylester- und Alkanoylsubstituenten können dabei geradkettig oder verzweigt sein. Als typische Alkyl-, Alkoxy-, Alkylthio-, Monocarbonsäurealkylester- bzw. Alkanoylsubstituenten seien Methyl, Äthyl, n-Propyl, Isopropyl, n-Butyl, sek.-Butyl, tert.-Butyl, n-Pentyl, n-Hexyl und n-Octyl, Methoxy, Äthoxy, n-Propoxy, Isopropoxy, n-Butoxy, n-Hexyloxy und n-Octyloxy, Methylthio, Äthylthio, n-Propylthio, Isopropylthio, n-Butylthio, n-Pentylthio und n-Hexylthio, Carbonsäuremethyl-, -äthyl-, -n-propyl-, -isopropyl-, -n-butyl- und -n-pentylester bzw. Acetyl, Propionyl, Butyryl und Valeroyl genannt. Dabei sind Alkyl-, Alkoxy-, Alkylthio- und Monocarbonsäurealkylestergruppen mit 1 bis 4 und insbesondere 1 oder 2 Kohlenstoffatomen in den Alkylteilen sowie Alkanoylgruppen mit 2 oder 3 Kohlenstoffatomen bevorzugt. Als substituierte π-Arene oder Anionen von substituierten π-Arenen werden solche bevorzugt, die einen oder zwei der obengenannten Substituenten, insbesondere Chlor- oder Bromatome, Methyl-, Äthyl-, Methoxy-, Äthoxy-, Cyan-, Carbonsäuremethyl- oder -äthylestergruppen und Acetylgruppen, enthalten.

Als $R^1$ und $R^2$ können gleiche oder verschiedene π-Arene vorliegen. Als heteroaromatische π-Arene eignen sich S-, N- und/oder O-Atome enthaltende Systeme. Heteroaromatische π-Arene, die S- und/oder O-Atome enthalten, sind bevorzugt. Beispiele für geeignete π-Arene sind Benzol, Toluol, Xylole, Äthylbenzol, Methoxybenzol, Äthoxybenzol, Dimethoxybenzol, p-Chlortoluol, Chlorbenzol, Brombenzol, Dichlorbenzol, Acetylbenzol, Trimethylbenzol, Trimethoxybenzol, Naphthalin, 1,2-Dihydronaphthalin, 1,2,3,4-Tetrahydronaphthalin, Methylnaphthaline, Methoxynaphthaline, Äthoxynaphthaline, Chlornaphthaline, Bromnaphthaline, Biphenyl, Inden, Biphenylen, Fluoren, Phenanthren, Anthracen, 9,10-Dihydroanthracen, Triphenylen, Pyren, Naphthacen, Coronen, Thiophen, Chromen, Xanthen, Thioxanthen, Benzothiophen, Naphthothiophen, Thianthren, Diphenyloxyd, Diphenylsulfid, Acridin und Carbazol.

Wenn a 2 ist, stellt $R^2$ vorzugsweise je das Anion eines π-Arens dar, und M ist jeweils das gleiche Metallatom. Beispiele für Anionen substituierter π-Arene sind die Anionen des Methyl-, Äthyl-, n-Propyl- und n-Butylcyclopentadiens, die Anionen des Dimethylcyclopentadiens, der Cyclopentadiencarbonsäuremethyl- und -äthylester sowie des Acetylcyclopentadiens, Propionylcyclopentadiens, Cyancyclopentadiens und Benzoylcyclopentadiens. Bevorzugte Anionen sind das Anion des unsubstituierten Indens und insbesondere des unsubstituierten Cyclopentadiens.

Bevorzugt hat a den Wert 1, und $R^1$ steht für Benzol, Toluol, Xylol, Methoxybenzol, Chlorbenzol, p-Chlortoluol, Naphthalin, Methylnaphthalin, Chlornaphthalin, Methoxynaphthalin, Biphenyl, Inden, Pyren oder Diphenylensulfid, und $R^2$ steht für das Anion des Cyclopentadiens, Acetylcyclopentadiens oder Indens oder für Benzol, Toluol, Xylol, Trimethylbenzol, Naphthalin oder Methylnaphthalin.

Besonders bevorzugt sind solche Komplexe der Formel I, worin a 1 ist, $R^1$ für $\eta^6$-Pyren oder $\eta^6$-Naphthalin und $R^2$ für das Anion des $\eta^5$-Cyclopentadiens stehen, n vorzugsweise 1 oder 2, insbesondere 1, und q vorzugsweise 1 sind. M ist beispielsweise $Ti^+$, $Ti^{2+}$, $Ti^{3+}$, $Zr^+$, $Zr^{2+}$, $Zr^{3+}$, $Hf^+$, $Hf^{2+}$, $Hf^{3+}$, $Nb^+$, $Nb^{3+}$, $Cr^+$, $Mo^+$, $Mo^{2+}$, $W^+$, $W^{2+}$, $Mn^+$, $Mn^{2+}$, $Re^+$, $Fe^{2+}$, $Co^{2+}$, $Co^{3+}$, $Ni^{2+}$ oder $Cu^{2+}$. Vorzugsweise ist M ein Chrom-, Kobalt-, Mangan-, Wolfram- oder Molybdänkation, insbesondere ein Eisenkation, und besonders bevorzugt $Fe^{2+}$.

Beispiele für geeignete Metalle oder Nichtmetalle L sind Sb, Fe, Sn, Bi, Al, Ga, In, Ti, Zr, Sc, V, Cr, Mn und Cu; Lanthanide wie Ce, Pr und Nd oder Actinide wie Th, Pa, U oder Np. Geeignete Nichtmetalle sind insbesondere B, P und As. L ist vorzugsweise P, As, B oder Sb, wobei P besonders bevorzugt wird.

Komplexe Anionen $[LQ_m]^{-q}$ sind beispielsweise $BF_4$, $PF_6$, $AsF_6$, $SbF_6$.

Beispiele für Verbindungen der Formel II sind ($\eta^6$-Toluol)($\eta^5$-indenyl)-eisen(II)-hexafluorphosphat, ($\eta^6$-Pyren)($\eta^5$-cyclopentadienyl)-eisen-(II)-hexafluorantimonat, ($\eta^6$-Toluol)($\eta^5$-cyclopentadienyl)-eisen(II)-hexafluorphosphat, ($\eta^6$-Naphthalin)($\eta^5$-cyclopentadienyl)-eisen(II)-hexafluorarsenat und ($\eta^6$-Benzol)($\eta^5$-cyclopentadienyl)-kobalt(III)-bis(tetrafluorborat). Solche Metallocensalze sind z.B. in der EP-A-0 094 915 beschrieben.

Die Photoinitiatoren können in einer Menge von 0,1–15 Gew.-%, vorzugsweise 0,1–10 Gew.-% und insbesondere 0,5–5 Gew.-% eingesetzt werden, bezogen auf das Epoxidharz.

Die Herstellung der im erfindungsgemäßen Verfahren verwendeten Resistlaminate erfolgt nach üblichen Verfahren, indem man zunächst z.B. die einzelnen Komponenten in einem geeigneten inerten Lösungsmittel auflöst.

Geeignete organische Lösungsmittel sind polare, besonders polare, aprotische Lösungsmittel, die alleine oder in Mischungen aus mindestens zwei Lösungsmitteln verwendet werden können. Geeignete Lösungsmittel sind zum Beispiel: Äther wie Diäthyläther, Dibutyläther, Tetrahydrofuran, Dioxan, Methyl-

äthylenglykol, Dimethyläthylenglykol, Dimethyldiäthylenglykol, Diäthyldiäthylenglykol, Dibutyldiäthylenglykol, Dimethyltriäthylenglykol, halogenierte Kohlenwasserstoffe wie Methylenchlorid, Chloroform, Tetrachlorkohlenstoff, 1,2-Dichloräthan, 1,1,2-Trichloräthan, 1,1,2,2-Tetrachloräthan, Carbonsäureester und Lactone wie Propylencarbonat, Essigsäureäthylester, Propionsäuremethylester, Benzoesäureäthylester, Äthylglykolacetat, 2-Methoxyäthylacetat, γ-Butyrolacton, γ-Valerolacton und Mevalolacton, Sulfoxide, wie Dimethylsulfoxid, Tetramethylsulfoxid, Sulfone wie Dimethylsulfon, Diäthylsulfon, Trimethylensulfon, Tetramethylensulfon, Ketone wie Dimethylketon, Methyläthylketon, Methylisobutylketon und Cyclohexanon, sustituierte Benzole wie Chlorbenzol und Nitrobenzol.

In diesem Stadium können weitere übliche Zusatzmittel einverleibt werden, z.B. Füllstoffe, Haftvermittler, Farbstoffe, die die Wirkung der Initiatoren nicht negativ beeinflussen, und Sensibilisatoren. Beispiele für Sensibilisatoren sind:

Perylen, 9,10-Dichloranthracen, 9,10-Diphenylanthracen, 3,4-Benzopyren, 1-Chloranthracen, 2-Methylanthracen, 9-Methylanthracen, 2-t-Butylanthracen, Anthracen, 1,12-Benzperylen, trans-1,3,5-Hexatrien, 1,2-Benzanthracen, Pyren, Pentaphen, Diphenyltetraacetylen, trans-Stilben, 1,2,3,4-Dibenzanthracen, 1,2,5,6-Dibenzanthracen, 1,3-Cyclohexadien, 1,2,7,8-Dibenzanthracen, 1,2-Benzopyren, Fluoranthen, 1,2-Benzochrysen, Tetraacetylenglykol, Diäthyltetraacetylen, 1-Aminonaphthalin, Benzil, Coronen, 1-Nitronaphthalin, 3,4-Benzofluoren, Diphenyltriacetylen, 2,2'-Binaphthyl, 1-Naphthalehyd, 5,6-Benzochrysen, 1-Acetylnaphthalin, 3,4,5,6-Dibenzophenanthren, cis-Stilben, 2,3-Butandion, Chrysen, 1,2-Benzofluoren, 2,3-Benzofluoren, 1-Benzoylnaphthalin, 1-Naphthonitril, Naphthalin-1-carbonsäure, Diphenyldiacetylen, 1,2,6,7-Dibenzopyren, Cyclopentadien, 9-Acetylphenanthren, p-Terphenyl, 1-Naphthol, 1-lodonaphthalin, 2-Phenylnaphthalin, 3,4-Benzophenanthren, 3-Acetylphenanthren, 1-Bromnaphthalin, 1-Chlornaphthalin, 2-Naphthonitril, Acenaphthen, trans-1,3-Pentadien, 2-Naphthaldehyd, Naphthalin-2-carbonsäure, 2-Acetylnaphthalin, 2-Benzoylnaphthalin, 2,4-Hexadien-1-ol, 1-Methylnaphthalin, 1-Methoxynaphthalin, 1,3-Butadien, 1-Fluornaphthalin, Isopren, 2-Iodnaphthalin, 2-Bromnaphthalin, 2-Chlornaphthalin, 2-Naphthol, 4-Phenylbenzophenon, 4-Phenylacetophenon, 2-Methylnaphthalin, Naphthalin, o-Terphenyl, Styrol, Phenanthren, 4,4'-Bis-dimethylaminobenzophenon, Diphenylacetylen, Anthrachinon, 4,4'-Dichlorbiphenyl, Triacetylenglykol, 4-Hydroxybiphenyl, 2,4,6-Octatriyn, m-Terphenyl, 2-Brombiphenyl, Thioxanthon, 2-Isopropylthioxanthon, 2-Chlorthioxanthon, 2-Dodecylthioxanthon, 1-Methoxycarbonylthioxanthon, 2-Äthoxycarbonylthioxanthon, 3-(2-Methoxyäthoxycarbonyl)-thioxanthon, 4-Butoxycarbonylthioxanthon, 1-Cyano-3-chlorthioxanthon, Biphenyl, 3,4-Methylendioxyacetophenon, 4-Cyanobenzophenon, Triphenylen, 4-Benzoylpyridin, 2-Benzoylpyridin, Fluoren, 4,4'-Dichlorbenzophenon, 4-Trifluormethylbenzophenon, 3-Methoxybenzophenon, 4-Chlorbenzophenon, 3-Chlorbenzophenon, 4,4'-Dibrombenzophenon, 3-Benzoylpyridin, 4-Methoxybenzophenon, 3,4-Dimethylbenzophenon, 4-Methylenbenzophenon, Benzophenon, 2-Methylbenzophenon, 4,4'-Dimethylbenzophenon, 2,5-Dimethylbenzophenon, 2,4-Dimethylbenzophenon, 4-Cyanoacetophenon, 4-Fluorbenzophenon, o-Benzylbenzophenon, α-Chloracetophenon, Diphenylenoxyd, Carbazol, 4,4'-Dimethoxybenzophenon, 4-Acetylpyridin, 3,4,5-Trimethylacetophenon, p-Dicyanobenzol, 4-Methoxybenzaldehyd, 4-Methylbenzaldehyd, 3,5-Dimethylacetophenon, 4-Bromacetophenon, 4-Methoxyacetophenon, 3,4-Dimethylacetophenon, Benzaldehyd, Triphenylmethylacetophenon, Anthron, 4-Chloracetophenon, 4-Trifluormethylacetophenon, Phenylacetylen, 2,4,6-Trimethylacetophenon, 3-Methoxyacetophenon, 3-Methylacetophenon, o-Dicyanobenzol, 1-Tetralon, 3-Bromacetophenon, 4-Methylacetophenon, 3-Cyanoacetophenon, 3-Trifluormethylacetophenon, Hexachlorbenzol, Xanthon, Acetophenon, 2-Phenylbutyrophenon, Allylacetophenon, β-Phenylpropiophenon, Valerophenon, Propiophenon, Butyrophenon, 2-Äthoxycarbonyl-3-nitrothioxanthon, 3-Thiophenylphthalimid, N-Methyl-4-thiophenylphthalimid.

Bevorzugt sind Thioxanthone, Phthalimidthioäther und besonders Anthracene. Diese werden bevorzugt in einer Menge von 0,1–20 Gew.-%, vorzugsweise 0,1–5 Gew.-% zugegeben, bezogen auf das Epoxidharz.

Die Lösung wird mittels üblicher Methoden auf das Trägermaterial aufgebracht, z.B. durch Tauchen, Streichen, Sprühen, Schleudern, mit Hilfe eines Schlitzgießers oder durch Walzenauftrag. Die Schichtdicken liegen je nach Verwendungszweck im Bereich von 10 bis etwa 200 μm. Nach dem Beschichten wird das Lösungsmittel entfernt, z.B. unter Erwärmen und gegebenenfalls zusätzlich im Vakuum.

Das Trägermaterial kann transparent oder opak sein, und es ist bevorzugt flexibel. Bevorzugt werden Spezialpapiere und besonders Kunststoffolien, insbesondere solche aus Polyäthylenterephthalat, die auch pigmentiert sein können.

Die auf dem Trägermaterial befindliche Schicht kann mit einer Deckfolie zum Schutz gegenüber Staub und mechanischer Verletzung geschützt werden, es eignen sich dazu z.B. Polyolefinfolien oder Silikonpapier. Wenn das Trägermaterial und die Deckfolie gegenüber aktinischer Strahlung undurchlässig sind, kann das Laminat ohne Gefahr bei Tageslicht gehandhabt werden. Es kann daher zweckmäßig sein, Trägermaterial und Deckfolie entsprechend einzufärben.

Das erfindungsgemäße Verfahren kann im einzelnen z.B. wie folgt ausgeführt werden. Die Oberfläche des Substrates wird zunächst gereinigt. Das Substrat kann je nach Verwendungszweck aus unterschiedlichen Materialien sein, z.B. Kunststoffe, Metalle, Metallegierungen, Halbmetalle, Halbleiter, Glas, Keramik, $SiO_2$ oder $Si_3N_4$.

Danach wird die strahlungsempfindliche Schicht, gegebenenfalls nach Entfernen der Deckfolie, vom Trägermaterial auf das Substrat übertragen, was im allgemeinen unter Anwendung von Druck und Wärme geschieht. Die Erwärmung kann hierbei auf bis zu 150 °C erfolgen.

Es ist ein besonderer Vorteil des erfindungsgemäßen Verfahrens, daß man das Trägermaterial nach dem Laminieren entfernen kann, weil die strahlungsempfindliche Schicht klebfrei ist, die dann durch Bestrahlung weiter modifiziert werden kann.

In der Weiterführung des erfindungsgemäßen Verfahrens wird die Schicht nach dem Bestrahlen thermisch gehärtet, bevorzugt bei Temperaturen von 50 bis 150 °C, besonders 80 bis 130 °C. Hierbei werden praktisch nur die bereits belichteten Anteile thermisch gehärtet.

Durch Bestrahlung und anschließender thermischer Härtung lassen sich besonders resistente Schutzschichten auf Substraten erzeugen. Zur Erzeugung photographischer Abbildungen wird die Bestrahlung durch eine Photomaske vorgenommen und darauf das Bild durch Behandlung mit einem Lösungsmittel entwickelt.

Die Bestrahlung der härtbaren Gemische erfolgt zweckmäßig mit Elektronenstrahlen oder aktinischem Licht, vorzugsweise einer Wellenlänge von 200 bis 600 nm und einer Intensität von 150 bis 8000 Watt. Als Lichtquellen eignen sich beispielsweise Xenonlampen, Argonlampen, Wolframlampen, Kohlelichtbögen, Metallhalogenid- und Metallichtbogenlampen, wie Niederdruck-, Mitteldruck- und Hochdruckquecksilberlampen. Vorzugsweise wird die Bestrahlung mit Metallhalogenid- oder Hochdruckquecksilberlampen durchgeführt. Die Bestrahlungszeit hängt von verschiedenen Faktoren ab, z.B. der Schichtdicke der verwendeten Kopierschicht, der Art der Lichtquelle und deren Abstand vom bestrahlten Verbund. Die Bestrahlungszeit kann z.B. vorzugsweise 10–120 Sekunden betragen.

Das Erwärmen zur thermischen Nachbehandlung der belichteten Zusammensetzungen kann in herkömmlichen Konvektionsöfen stattfinden. Sind kurze Erhitzungs- oder Reaktionszeiten erforderlich, so kann das Erhitzen durch Belichtung mit beispielsweise IR-Strahlung, IR-Lasern oder Mikrowellengeräten erfolgen. Die Härtungszeit liegt im Bereich zwischen ca. 1 und 10 Minuten.

Entwickelt wird mit organischen Lösungsmitteln, in denen die verwendeten Epoxidharze löslich sind. Dieser Verfahrensschritt kann mechanisiert und z.B. mit einem Sprühentwicklungsgerät oder einem Durchlaufentwicklungsgerät durchgeführt werden. Eine Entwicklung durch einfaches Überwischen oder durch Behandlung mit Lösungsmitteldampf ist ebenfalls möglich. Geeignete Lösungsmittel wurden zuvor schon erwähnt.

Die an den Nichtbildstellen freigelegte Oberfläche kann anschließend je nach Verwendungszweck nachbehandelt oder modifiziert werden. Die Oberflächen können beispielsweise geätzt, galvanisch oder stromlos metallisiert, mit Ionen implantiert, hydrophilisiert, anodisiert, gelötet oder lackiert werden.

Hauptanwendungsgebiete für das erfindungsgemäße Verfahren sind die Herstellung von gedruckten Schaltungen, Lötstopmasken, Hoch- und Tiefdruckformen, Namensschildern, Offsetdruckplatten und Schablonen.

Gehärtete Epoxidharze zeichnen sich durch gute thermomechanische, chemische und elektrische Eigenschaften aus, z.B. thermische Stabilität, gute Haftung auf Substraten, hohen spezifischen Durchgangswiderstand, gute Galvano-, Ätz- und Lötbadbeständigkeit.

Das erfindungsgemäße Verfahren ermöglicht es, diese Vorteile gegenüber einer Direktbeschichtung mit Lösungen mit einer technisch weniger aufwendigen und einfachen Handhabung zu verbinden, wobei die folgenden Vorteile der erfindungsgemäß verwendeten strahlungsempfindlichen Photoresistlaminate zusätzlich vorhanden sind: Verringerter Kaltfluß der strahlungsempfindlichen Schicht und damit Eliminierung des Verklebens der Folienränder; hohe Lichtempfindlichkeit; gute Lagerstabilität und Direktbelichtung der Schicht, wodurch eine bessere Auflösung erzielt wird. Es wurde ferner gefunden, daß durch den Laminiervorgang auch eine bessere Kantenabdeckung von ausgebildeten Leiterzügen erzielt wird.

Die nachfolgenden Beispiele erläutern die Erfindung näher:

Beispiele 1–4

Eine Lösung, bestehend aus 10 g eines Epoxidharzes und 0,06 mmol ($\eta^6$-1-Methylnaphthalin)-($\eta^5$-cyclopentadienyl)-eisen(II)-hexafluorphosphat in 4 g 1-Acetoxy-2-äthoxyäthan, wird mit einem 75-µm-Drahtrakel auf eine Polyesterfolie (Polyäthylenterephthalat) aufgebracht. Nach dem Trocknen bei 80 °C wird der erhaltene Film (Dicke: 150 µm) bei 130 °C mit einem Rollenlaminator auf eine kupferkaschierte Epoxidplatte aufgebracht. Danach wird unter einem 21stufigen Stouffer-Keil mit einer 500-W-Metallhalogenid-Lampe in einem Abstand von 50 cm belichtet und anschließend gehärtet. Als Entwickler wird ein Gemisch aus 1,1,1-Trichloräthan und Äthylmethylketon im Verhältnis 1:1 eingesetzt. Als Maß der Lichtempfindlichkeit wird die letzte vollständig abgebildete Stufe angegeben.

| Beispiel | Epoxidharz | Epoxid-wert (Äq/kg) | Belich-tungszeit (Sek.) | Härtungs-zeit (Min.) | Härtungstem-peratur (°C) | Entwick-lungszeit (Sek.) | Stufe |
|---|---|---|---|---|---|---|---|
| 1 | Epoxidkresolnovolak | 4,5 | 30 | 2 | 100 | 15 | 4 |
| | | | 30 | 2 | 120 | 15 | 5 |
| | | | 60 | 2 | 100 | 15 | 5 |
| | | | 120 | 5 | 120 | 30 | 10 |
| 2 | Bisphenol-A-diglycidyläther | 1,35 | 30 | 2 | 100 | 15 | 3 |
| | | | 30 | 2 | 120 | 15 | 3 |
| | | | 60 | 2 | 100 | 15 | 4 |
| | | | 120 | 5 | 120 | 30 | 7 |
| 3 | Bisphenol-A-diglycidyläther | 2,41 | 30 | 2 | 100 | 15 | 4 |
| | | | 60 | 2 | 100 | 100 | 6 |
| | | | 30 | 2 | 120 | 15 | 4 |
| | | | 120 | 5 | 120 | 30 | 8 |
| 4 | Bisphenol-A-diglycidyläther | | 30 | 2 | 110 | 30 | 4 |
| | vorverlängert mit | | 120 | 5 | 110 | 30 | 9 |
| | Tetrabrombisphenol A | | 120 | 5 | 100 | 30 | 10 |

Beispiele 5–8

10 g eines technischen Epoxidkresolnovolaks (Epoxidgehalt: 4,5 Äq/kg) und 0,25 g eines Photoinitiators werden in 4 g 1-Acetoxy-2-äthoxyäthan gelöst und mit einem 75-µm-Drahtrakel auf eine Polyesterfolie aufgebracht. Nach dem Trocknen bei 80 °C wird der erhaltene Film (Dicke: ~50 µm) bei 130 °C auf eine kupferkaschierte Epoxidplatte laminiert. Belichtet wird unter einem 21stufigen Stouffer-Keil mit einem 5000-W-Metallhalogenidbrenner (Abstand 50 cm) und darauf gehärtet. Als Entwickler wird ein Gemisch aus 1,1,1-Trichloräthan und Äthylmethylketon 1:1 eingesetzt. Als Maß für die Lichtempfindlichkeit wird die letzte vollständig abgebildete Stufe angegeben.

| Beispiel | Initiator | Belichtungs-zeit (Sek.) | Härtungszeit (Min.) | Härtungs-temperatur (°C) | Entwicklungs-zeit (Sek.) | Stufe |
|---|---|---|---|---|---|---|
| 5 | ($\eta^6$-Naphthalin)-($\eta^5$-cyclopentadie- | 30 | 2 | 110 | 1 | 11 |
| | nyl)-eisen(II)-hexafluorantimonat | 5 | 2 | 110 | 1 | 7 |
| 6 | Triphenylsulfoniumhexafluorphos- | 30 | 10 | 110 | 1 | 4 |
| | phat-2-Methyl-anthracen* | 30 | 2 | 110 | 1 | 1 |
| 7 | Diphenyljodoniumhexafluorantimo- | 30 | 10 | 110 | 1 | 15 |
| | nat-2-Methyl-anthracen* | 30 | 2 | 110 | 1 | 15 |
| | | 5 | 2 | 110 | 1 | 9 |
| 8 | Diphenyljodosylhexafluorphosphat- | 30 | 10 | 110 | 1 | 2 |
| | 2-Methyl-anthracen* | | | | | |

* 2,5 Gew.-%, bezogen auf Epoxidkresolnovolak

Beispiele 9–12

10 g eines technischen Epoxidkresolnovolaks (Epoxidgehalt: 4,5 Äq/kg) und 0,06 mmol ($\eta^6$-1-Methylnaphthalin)-($\eta^5$-cyclopentadienyl)-eisen(II)-hexafluorphospaht werden in 4 g 1-Acetoxy-2-äthoxyäthan gelöst und mit einem 75-µm-Drahtrakel auf eine Polyesterfolie aufgebracht. Der so erhaltene Film wird bei 80 °C getrocknet und bei 130 °C mit einem Rollenlaminator auf verschiedene Substrate auflaminiert. Belichtet wird danach unter einem 21stufigen Stouffer-Keil mit einem 5000-W-Metallhalogenidbrenner (Abstand ~50 cm) und darauf bei 110 °C gehärtet. Als Entwickler wird ein Gemisch aus 1,1,1-Trichloräthan und Äthylmethylketon 1:1 eingesetzt. Als Maß für die Lichtempfindlichkeit wird die letzte vollständig abgebildete Stufe angegeben.

| Beispiel | Substrat | Belichtungszeit und Härtungszeit | Belichtungszeit (Sekunden) 30 | | 60 | |
|---|---|---|---|---|---|---|
| | | | Härtungszeit (Minuten) | | Härtungszeit (Minuten) | |
| | | | 2 | 10 | 2 | 10 |
| 9 | elektrochemisch aufgerauhtes Aluminium (der Firma Rotaprint) | | 4 | 11 | 7 | 13 |
| 10 | Polyesterfolie (Mylar) | | 6 | 8 | 8 | 12 |
| 11 | Phenolformaldehydharz-getränktes Papier (Spezifikation FR2) | | 2 | 4 | 6 | 8 |
| 12 | Kupferbeschichtetes Epoxidlaminat (Cu-Vetronit) | | 2 | 6 | 8 | 9 |

Beispiel 13

10 g eines technischen Epoxidkresolnovolaks (Epoxidgehalt 4,5 Äq/kg), 0,15 g ($\eta^6$-1-methylnaphthalin)-($\eta^5$-cyclopentadienyl)-eisen(II)-hexafluorphosphat und 0,3 g eines Farbstoffes der Formel

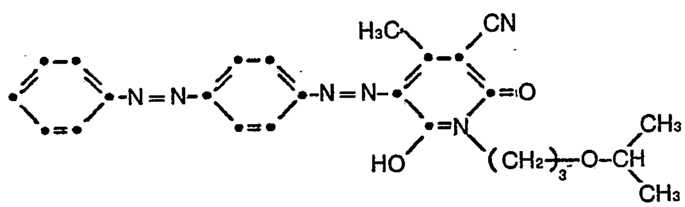

werden in einer Mischung aus 4 g 1-Acetoxy-2-äthoxyäthan und 1 g Cyclohexanon gelöst und mit einem 75-µm-Drahtrakel auf eine Polyesterfolie aufgebracht. Der so erhaltene Film wird bei 80 °C getrocknet und anschließend bei 130 °C mit einem Rollenlaminator auf eine kupferkaschierte Epoxidplatte auflaminiert (Trockenfilmdicke 30 µm). Dann wird durch eine Negativ-Vorlage einer gedruckten Schaltung mit einer Quecksilberhochdrucklampe belichtet (5000 W, Abstand zum Brenner 50 cm) und die belichtete Platte während 5 Minuten bei 110 °C ausgehärtet. Das Entwickeln der belichteten und gehärteten Platte wird in 1-Acetoxy-2-äthoxyäthan vorgenommen, wobei die nicht belichteten Stellen weggelöst weden. Man erhält so die Abbildung der Vorlage. Durch Ätzen in einer 50%igen $FeCl_3$-Lösung werden die blanken Kupferteile weggelöst, und es resultiert das Leiterbild der gewünschten Schaltung.

Beispiel 14

6 g eines technischen Epoxidkresolnovolaks (Epoxidgehalt 4,5 Äq/kg), 4 g Allylglycidyläther, 0,15 g ($3{,}68 \times 10^{-4}$ Mol) ($\eta^6$-1-methylnaphthalin)-($\eta^5$-cyclopentadienyl)-eisen(II)-hexafluorphosphat und 1,5 g eines chlorierten Phthaloxcyaninfarbstoffes (Color Index No. 74260) werden in einer Mischung aus 4 g 1-Acetoxy-2-äthoxyäthan und 1 g Cyclohexanon gelöst und mit einem 75-µm-Drahtrakel auf eine Polyesterfolie aufgebracht. Der so erhaltene Film wird bei 80 °C getrocknet (Trockenfilmdicke 30 µm). Anschließend wird der Film mittels eines Rollenlaminators auf eine kupferkaschierte Epoxidplatte auflaminiert. Diese Platte wird dann durch eine Negativvorlage einer Lötstoppmaske mit einer Quecksilber-Hochdrucklampe belichtet (5000 W, Abstand zum Brenner 50 cm). Die belichtete Platte wird bei 110 °C während ca. 5 Minuten gehärtet und nach dem Abkühlen in 1-Acetoxy-2-äthoxyäthan entwickelt. Man erhält die Abbildung der gewünschten Vorlage, wobei die Lötaugen freiliegen. Die Platte wird nun in einem Lötbad bei 250 °C verzinnt, wobei nur die freiliegenden Kupferstellen verzinnt werden. Der gehärtete Photoresist widersteht dieser Behandlung auch bei 10facher Wiederholung des Verzinnungszyklus.

## Patentansprüche

1. Verfahren zur Herstellung einer Schutzschicht oder einer Reliefabbildung auf einem Substrat, bei dem eine strahlungsempfindliche Schicht von einem Trägermaterial auf das Substrat übertragen, darauf direkt oder unter einer Photomaske belichtet und danach thermisch gehärtet wird, und darauf gegebenenfalls unbelichtete Anteile mit einem Lösungsmittel entwickelt werden, dadurch gekennzeichnet, daß die strahlungsempfindliche Schicht aus einem festen filmbildenden Epoxidharz besteht, das einen strahlungsaktivierbaren Photoinitiator für die Polyaddition enthält.

2. Verfahren gemäß Anspruch 1, dadurch gekennzeichnet, daß ein Farbstoff in der lichtempfindlichen Schicht enthalten ist.

3. Verfahren gemäß Anspruch 1, dadurch gekennzeichnet, daß die Härtungstemperatur im Bereich von 50 °C bis 150 °C liegt.

4. Verfahren gemäß Anspruch 1, dadurch gekennzeichnet, daß das Epoxidharz ein Epoxidäquivalentgewicht von 1 bis 5 Äquivalenten pro kg Harz aufweist.

5. Verfahren gemäß Anspruch 1, dadurch gekennzeichnet, daß der Photoinitiator in einer Menge von 0,1 bis 15 Gew.-% einverleibt ist, bezogen auf das Epoxidharz.

6. Verfahren gemäß Anspruch 1, dadurch gekennzeichnet, daß der Photoinitiator einer Verbindung der Formel I entspricht

$$[(R^1)(R^2M)_a]^{+an} \frac{an}{q} [LQ_m]^{-q} \quad (I),$$

worin a 1 oder 2 sowie n und q unabhängig voneinander je eine ganze Zahl von 1 bis 3 sind, M das Kation eines einwertigen bis dreiwertigen Metalls aus Gruppe IVb bis VIIb, VIII oder Ib des Periodensystems darstellt, m eine ganze Zahl ist, die der Summe der Wertigkeit von L und q entspricht, und Q ein Halogenatom, L ein zweiwertiges bis siebenwertiges Metall oder Nichtmetall, $R^1$ ein π-Aren und $R^2$ ein π-Aren oder das Anion eines π-Arens bedeuten.

7. Verfahren gemäß Anspruch 1, dadurch gekennzeichnet, daß der Photoinitiator ein Haloniumsalz der Formel II ist,

$$[R^3R^4X]^+_q \ [LQ_m]^{-q} \quad (II)$$

worin $R^3$ und $R^4$ unabhängig voneinander ein carbozyklischer oder heterozyklischer aromatischer Rest mit 6 bis 20 C-Atomen oder $R^3$ und $R^4$ zusammen ein zweiwertiger carbozyklischer oder heterozyklischer aromatischer Rest sind, X für ein Halogenatom steht, m eine Zahl ist, die der Summe der Wertigkeit von L und q entspricht, L ein zweiwertiges bis siebenwertiges Metall oder Nichtmetall und Q ein Halogenatom darstellen, und q eine Zahl von 1 bis 3 bedeutet.

8. Verfahren gemäß Anspruch 1, dadurch gekennzeichnet, daß der Photoinitiator ein Sulfoniumsalz der Formel III ist,

$$[R^5R^6R^7S]^+_q \ [LQ_m]^{-q} \quad (III),$$

worin $R^5$, $R^6$ und $R^7$ unabhängig voneinander einen carbozyklischen oder heterozyklischen aromatischen Rest mit 6 bis 20 C-Atomen oder eines von $R^5$, $R^6$ und $R^7$ diesen aromatischen Rest und die beiden anderen zusammen einen zweiwertigen carbozyklischen oder heterozyklischen aromatischen Rest bedeuten, m eine Zahl ist, die der Summe der Wertigkeit von L und q entspricht, L ein zweiwertiges bis siebenwertiges Metall oder Nichtmetall und Q ein Halogenatom darstellen, und q eine Zahl von 1 bis 3 bedeutet.

9. Verfahren gemäß Anspruch 1, dadurch gekennzeichnet, daß der Photoinitiator ein Jodosylsalz der Formel IV

$$[R^8R^9J^+=O]_q \ [LQ_m]^{-q} \quad (IV),$$

worin $R^7$ und $R^8$ ein carbozyklischer oder heterozyklischer aromatischer Rest mit 6 bis 20 C-Atomen sind, m eine Zahl ist, die der Summe der Wertigkeit von L und q entspricht, L ein zweiwertiges bis siebenwertiges Metall oder Nichtmetall und Q ein Halogenatom darstellen, und q eine Zahl von 1 bis 3 bedeutet.

10. Verfahren gemäß Anspruch 1, dadurch gekennzeichnet, daß zusätzlich ein Sensibilisator in der lichtempfindlichen Schicht enthalten ist.

11. Verfahren gemäß Anspruch 1, dadurch gekennzeichnet, daß das Epoxidharz ein mit zweiwertigen Phenolen vorverlängerter Diglycidyläther von aliphatischen Diolen mit 2 bis 4 C-Atomen oder ein mit zweiwertigen Phenolen vorverlängerter Bisphenoldiglycidyläther ist, oder daß das Epoxidharz ein Glycidyläther eines Novolaks oder eines Bisphenols ist.

**Claims**

1. A process for the production of a protective layer or a relief image on a substrate, wherein a radiation-sensitive layer is transferred from a support to the substrate, then exposed directly or under a photomask and then hardened by the action of heat, after which, if appropriate, unexposed parts are developed with a solvent, and wherein the radiation-sensitive layer consists of a solid film-forming epoxy resin containing a photoinitiator, which can be activated by radiation, for the polyaddition reaction.

2. The process according to claim 1, wherein a dye is contained in the photosensitive layer.

3. The process according to claim 1, wherein the hardening temperature is in the range from 50 °C to 150 °C.

4. The process according to claim 1, wherein the epoxy resin has an epoxy equivalent weight of 1 to 5 equivalents per kg of resin.

5. The process according to claim 1, wherein the photo-initiator is incorporated in a quantity of 0.1 to 15% by weight based on the epoxy resin.

6. The process according to claim 1, wherein the photo-initiator corresponds to a compound of the formula I

$$[(R^1)(R^2M)_a]^{+an} \frac{an}{q} [LQ_m]^{-q} \quad (I),$$

wherein a is 1 or 2 and n and q independently of one another are each an integer from 1 to 3, M is the cation of a monovalent to trivalent metal from group IVb to VIIb, VIII or Ib of the periodic table, m is an integer corresponding to the sum of the values of L and q, Q is a halogen atom, L is a divalent to heptavalent metal or non-metal, $R^1$ is a π-arene and $R^2$ is a π-arene and $R^2$ is a π-arene or the anion of a π-arene.

7. The process according to claim 1, wherein the photo-initiator is a halonium salt of the formula II

$$[R^3R^4X]^+_q \ [LQ_m]^{-q} \quad (II)$$

wherein $R^3$ and $R^4$ independently of one another are a carbocyclic or heterocyclic aromatic radical having 6 to 20 C atoms, or $R^3$ and $R^4$ together are a divalent carbocyclic or heterocyclic aromatic radical, X is a halogen atom, m is a number corresponding to the sum of the values of L and q, L is a divalent to heptavalent metal or non-metal, Q is a halogen atom and q is a number from 1 to 3.

8. The process according to claim 1, wherein the photo-initiator is a sulfonium salt of the formula III

$$[R^5R^6R^7S]^+_q \ [LQ_m]^{-q} \quad (III),$$

wherein $R^5$, $R^6$ and $R^7$ independently of one another are a carbocyclic or heterocyclic aromatic radical

having 6 to 20 C atoms, or one of $R^5$, $R^6$ and $R^7$ is this aromatic radical and the other two together are a divalent carbocyclic or heterocyclic aromatic radical, m is a number corresponding to the sum of the values of L and q, L is a divalent to heptavalent metal or non-metal, Q is a halogen atom and q is a number from 1 to 3.

9. The process according to claim 1, wherein the photo-initiator is an iodosyl salt of the formula IV

$$[R^8R^9J^+=0]_q\ [LQ_m]^{-q} \qquad (IV),$$

wherein $R^7$ and $R^8$ are a carbocyclic or heterocyclic aromatic radical having 6 to 20 C atoms, m is a number corresponding to the sum of the values of L and q, L is a divalent to heptavalent metal or non-metal, Q is a halogen atom and q is a number from 1 to 3.

10. The process according to claim1, wherein a sensitizer is additionally contained in the photosensitive layer.

11. The process according to claim 1, wherein the epoxy resin is a diglycidyl ether, lengthened with dihydric phenols beforehand, of aliphatic diols having 2 to 4 C atoms, or a bisphenol diglycidyl ether lengthened with dihydric phenols beforehand, or wherein the epoxy resin is a glycidyl ether of a novolak or of a bisphenol.

**Revendications**

1. Procédé pour réaliser une couche protectrice ou une image en relief selon lequel on transfère une couche photosensible d'une matière support au substrat, puis on expose la couche à un rayonnement directement ou sous un photomasque et ensuite on la durcit par voie thermique, après quoi, le cas échéant, on élimine les parties qui n'ont pas été touchées par la lumière en effectuant un développement au moyen d'un solvant, ce procédé étant caractérisé en ce que la couche photosensible est constituée d'une résine époxydique feuillogène solide qui contient un photo-amorceur photo-activable pour la polyaddition.

2. Procédé selon la revendication 1 caractérisé en ce qu'il y a un colorant dans la couche photosensible.

3. Procédé selon la revendiction 1 caractérisé en ce que la température de durcissement est située dans l'intervalle allant de 50 à 150 °C.

4. Procédé selon la revendication 1 caractérisé en ce que la résine époxydique a un poids équivalent d'époxy de 1 et 5 équivalents par kilogramme de la résine.

5. Procédé selon la revendication 1 caractérisé en ce que le photo-amorceur est incorporé en une quantité de 0,1 à 15% en poids par rapport à la résine époxydique.

6. Procédé selon la revendication 1 caractérisé en ce que le photo-amorceur est un composé répondant à la formule I:

$$[(R^1)(R^2M)_a]^{+an}\ \frac{an}{q}\ [LQ_m]^{-q} \qquad (I),$$

dans laquelle

a est égal à 1 ou à 2,

n et q représentent chacun, indépendamment l'un de l'autre, un nombre entier de 1 à 3,

M représente le cation d'un métal univalent à trivalent pris dans l'un des groupes IVb à VIIb, VIII et Ib de la classification périodique,

m désigne un nombre entier égal à la somme de q et de la valence de L,

Q représente un atome d'halogène,

L représente un métal ou un non-métal dont la valence peut aller de 2 à 7,

$R^1$ représente un π-arène et

$R^2$ représente un π-arène ou l'anion d'un π-arène.

7. Procédé selon la revendication 1 caractérisé en ce que le photo-amorceur est un sel d'halonium répondant à la formule II:

$$[R^3R^4X]^+_q\ [LQ_m]^{-q} \qquad (II)$$

dans laquelle $R^3$ et $R^4$ représentent chacun, indépendamment l'un de l'autre, un radical aromatique carbocyclique ou hétérocyclique qui contient de 6 à 20 atomes de carbone, ou encore $R^3$ et $R^4$ forment ensemble un radical aromatique carbocyclique ou hétérocyclique bivalent, X représente un atome d'halogène, m désigne un nombre égal à la somme de q et de la valence de L, L représente un métal ou un non-métal dont la valence peut aller de 2 à 7, Q représente un atome d'halogène et q représente un nombre de 1 à 3.

8. Procédé selon la revendiction 1 caractérisé en ce que le photo-amorceur est un sel de sulfonium répondant à la formule III:

$$[R^5R^6R^7S]^+_q\ [LQ_m]^{-q} \qquad (III),$$

dans laquelle $R^5$, $R^6$ et $R^7$ représentent chacun, indépendamment les uns des autres, un radical aromatique carbocyclique ou hétérocyclique qui contient de 6 à 20 atomes de carbone, ou l'un des symboles $R^5$, $R^6$ et $R^7$ représente un tel radical aromatique et les deux autres forment ensemble un radical aromatique carbocyclique ou hétérocyclique bivalent, m désigne un nombre égal à la somme de q et de la valence de L, L représente un métal ou un non-métal dont la valence peut aller de 2 à 7, Q représente un atome d'halogène et q désigne un nombre de 1 à 3.

9. Procédé selon la revendication 1 caractérisé en ce que le photo-amorceur est un sel d'iodosyle répondant à la formule IV:

$$[R^8R^9J^+=0]_q\ [LQ_m]^{-q} \qquad (IV),$$

dans laquelle $R^7$ et $R^8$ représentent chacun un radical aromatique carbocyclique ou hétérocyclique contenant de 6 à 20 atomes de carbone, m désigne un nombre entier égal à la somme de q et de la valence de L, L représente un métal ou un non-métal dont la valence peut aller de 2 à 7, Q représente un atome d'halogène et q désigne un nombre de 1 à 3.

10. Procédé selon la revendication 1 caractérisé en ce que la couche photosensible contient en outre un sensibilisateur.

11. Procédé selon la revendication 1 caractérisé en ce que la résine époxydique est un éther diglycidylique qui dérive d'un diol aliphatique contenant de 2 à 4 atomes de carbone et qui a été pré-allongé par un diphénol, ou est un éther diglycidylique d'un bisphénol qui a été pré-allongé par un diphénol, ou est un éther glycidylique d'une novolaque ou d'un bisphénol.